# EUROPÄISCHE PATENTSCHRIFT

(11) **EP 2 396 448 B1**
(45) Veröffentlichungstag und Bekanntmachung des Hinweises auf die Patenterteilung: **08.10.2014**
(21) Anmeldenummer: 10709682.8
(22) Anmeldetag: 12.02.2010
(51) Int. Cl.: C23C 16/02, C23C 16/26, C22C 23/02, C22C 9/00, C22C 9/02, C22C 9/04, C22C 25/00, C23G 5/00

(54) **VERFAHREN ZUM AUFBRINGEN EINER BESCHICHTUNG AUF WERKSTÜCKE UND/ODER WERKSTOFFE AUFWEISEND MINDESTENS EIN LEICHT OXIDIERBARES NICHTEISENMETALL**
METHOD FOR APPLYING A COATING TO WORKPIECES AND/OR MATERIALS COMPRISING AT LEAST ONE READILY OXIDIZABLE NONFERROUS METAL
PROCÉDÉ POUR APPLIQUER UN REVÊTEMENT SUR DES PIÈCES ET/OU DES MATÉRIAUX PRÉSENTANT AU MOINS UN MÉTAL NON-FERREUX FACILEMENT OXYDABLE

(30) Priorität: 12.02.2009 DE 102009000821
(43) Veröffentlichungstag der Anmeldung: 21.12.2011
(73) Patentinhaber: Surcoatec AG, 6340 Baar (CH)
(72) Erfinder: NÖLL, Oliver, 56132 Becheln (DE)
(74) Vertreter: Michalski Hüttermann & Partner Patentanwälte mbB
(86) Internationale Anmeldenummer: PCT/EP2010/000889
(87) Internationale Veröffentlichungsnummer: WO 2010/091879

(56) Entgegenhaltungen:
- EP-A1- 0 483 839
- DE-C1- 19 718 516
- YAMADA, H, HIRAIDE, T, TAKEZAWA, N, ONO, A, FUSEGI, T, KURODA, S, YOSHIMOTO, M: "Study on improvements of tribological properties of magnesium alloys: Diamond-like carbon film coating with the interface layer of carbonaceous film containing silicon" JAPANESE JOURNAL OF TRIBOLOGY, Bd. 48, Nr. 4, 20. März 2003 (2003-03-20), - 31. Dezember 2003 (2003-12-31) Seiten 397-404, XP008122452

## Beschreibung

### Technisches Gebiet

Werkstücke und/oder Werkstoffe aufweisend oxidierbares Nichteisenmetalle werden in jüngerer Zeit zunehmend eingesetzt. Hierzu zählen insbesondere Leichtmetalle, die hohe mechanische Festigkeit mit geringem spezifischen Gewicht verbinden. Sie sind daher insbesondere für gewichtskritische Anwendungen wie Automotive und Aerospace stark nachgefragt.

So weist z.B. Magnesium bei vergleichbarer Festigkeit eine spezifische Dichte von 1,74 g/cm³ auf, während Aluminium eine Dichte von Dichte 2,7 g/m³ aufweist.

Obwohl viele leicht oxidierbare Nichteisenmetall zu den häufigsten Elementen der Geospähre gehören (Magnesium steht in der Elementhäufigkeit z.B. mit einem Anteil von 1,94% an achter Stelle), kommen sie unter atmosphärischen Bedingungen - also insbesondere auch in der gesamten Geosphäre - praktisch nicht in elementarer Form vor, da sie mit dem Luftsauerstoff äußerst schnell reagieren.

Dies liegt daran, dass sie im Vergleich zu Eisen bzw. Wasserstoff ein negatives elektrochemisches Standardpotential aufweisen.

Der Begriff "leicht oxidierbares Nichteisenmetall", wie hier verwendet, bezieht sich somit auf Technische Metalle und Metalllegierungen, die im Vergleich zu Eisen ein negatives Standardpotential aufweisen. Viele dieser Nichteisenmetalle sind Leichtmetalle. Bei Letzteren handelt es sich um all jene Metalle, die eine spezifische Dichte von weniger als 6 g/cm³ aufweisen. Die folgende Tabelle listet wichtige, im Sinne der vorliegenden Definition erfasste leicht oxidierbare Nichteisenmetalle auf; dabei wurden Eisen und Wasserstoff (beide kursiv dargestellt) als Vergleichsmaterialien herangezogen.

**Tabelle 1**

| | **Oxidierte Form** | **Standardpotential E₀ (V)** | **spezifische Dichte (g/cm³)** |
|---|---|---|---|
| *Wasserstoff* | *H⁺* | *0* | *n*/*n* |
| *Eisen* | *Fₑ²⁺* | *-0,04* | *7,87* |
| Zinn | Sn²⁺ | -0,14 | 7,3 |
| Zink | Zn²⁺ | -0,76 | 7,1 |
| Titan | Ti³⁺ | -1.21 | 4,51 |
| Aluminium | Al³⁺ | -1,66 | 2,7 |
| Beryllium | Be²⁺ | -1,85 | 1,85 |
| Magnesium | Mg²⁺ | -2,38 | 1,74 |

Leicht oxidierbare Nichteisenmetalle liegen in der Geosphäre stets in Form von Oxiden oder anderen Salzen vor, so z.B. in Form von Magnesiumoxid (MgO), Magnesiumchlorid (MgCl₂) oder Magnesiumsulfat (MgSO₄).

Magnesium hat z.B. einen relativ niedrigen Schmelz- und Siedepunkt. Beim Erhitzen verbrennt es oberhalb von 500°C mit blendend weißer Flamme zu Magnesiumoxid und Magnesiumnitrid:

2 Mg + O₂, -----> 2 MgO

3 Mg ₊ N₂ -----> Mg₃N₂

Magnesium brennt auch in anderen Gasen, in denen Sauerstoff chemisch gebunden ist, z.B. in Kohlenstoffdioxid oder in Schwefeldioxid.

In siedendem Wasser löst sich Magnesiumpulver unter Bildung von Magnesiumhydroxid und Wasserstoff auf:

Mg + 2 H₂O -----> Mg(OH)₂ + H₂

Mit Säuren bilden sich die entsprechenden Salze unter Wasserstoffbildung, z.B. bei der Reaktion mit Salzsäure:

Mg + 2 HCl ----> MgCl₂ + H₂

Um Magnesium für die Technik in elementarer Form verfügbar zu machen, wird wasserfreies Magnesiumchlorid, das nach aus Meerwasser gewonnen wird, dem Verfahren der Schmelzflusselektrolyse unterzogen. Alternativ wird Magnesium durch die thermische Reduktion von Magnesiumoxid hergestellt. Beide Verfahren sind sehr energieaufwändig.

Reines Magnesium findet in der Technik aufgrund der geringen Härte und der hohen Korrosionsanfälligkeit kaum Verwendung. Daher wird insbesondere Magnesium häufig in Form von Legierungen mit anderen Metallen, insbesondere Aluminium und Zink, verwendet (siehe Tabelle 3). Diese Legierungen zeichnen sich durch ihre geringe Dichte, ihre hohe Festigkeit und ihre Korrosionsbeständigkeit aus.

Berylllium liegt in der Geosphäre in der Regel als Bertrandit (4BeO·2SiO₂·H₂O), Beryll (Be₃Al₂(SiO₃)₆), Berylliumfluorid oder Berylliumchlorid vor. Elementares Beryllium lässt sich durch Reduktion von Berylliumfluorid mit Magnesium bei 900 °C oder durch Schmelzflusselektrolyse von Berylliumchlorid bzw. -fluorid herstellen.

Aluminium liegt in der Geosphäre in der Regel chemisch gebunden in Alumosilikaten, Aluminiumoxid (Korund) oder Aluminiumhydroxid (Al(OH)₃ und AlO(OH)) vor. Zur Gewinnung wird das in Bauxit enthaltene Aluminiumoxid/-hydroxid-Gemisch mit Natronlauge aufgeschlossen und dann in Drehrohröfen zu Aluminiumoxid (Al₂O₃) gebrannt. Anschließend erfolgt eine Schmelzflusselektrolyse. Dabei wird das Aluminiumoxid zur Herabsetzung des Schmelzpunktes in einer Kryolithschmelze aufgelöst Bei der Elektrolyse entsteht an der den Boden des Gefäßes bildenden Kathode elementares Aluminium.

Titan liegt in der Geosphäre in der Regel als Ilmenit (FeTiO₃), Perowskit (CaTiO₃), Rutil (TiO₂), Titahit (CaTi[SiO₄]O) oder Bariumtitanat, (BaTiO₃) vor. Zur Gewinnung wird angereichertes Titandioxid mit Chlor zu Titantetrachlorid in der Hitze umgesetzt. Anschließend erfolgt eine Reduktion zum Titan durch flüssiges Magnesium. Zur Herstellung von bearbeitbaren Legierungen muss der erhaltene Titanschwamm im Vakuum-Lichtbogenofen umgeschmolzen werden.

Zink liegt in der Geosphäre in der Regel in Form von Zinksulfiderzen, Smithsonit (ZnCO₃) oder seltenere als Hemimorphit Zn₄(OH)₂[Si₂O₇] oder Franklinit (Zn,Fe,Mn)(Fe₂Mn₂)O₄ vor. Die Gewinnung erfolgt durch Rösten von Zinksulfid-Erzen an der Luft. Dabei entsteht Zinkoxid, das mit feingemahlener Kohle vermengt und in einem Gebläseschachtofen auf 1100-1300 °C erhitzt wird. Dabei bildet sich zunächst Kohlenstoffmonoxid. Dieses reduziert dann das Zinkoxid zu metallischem Zink

Zinn liegt in der Geosphäre in der Regel als-Zinnoxid (SnO₂, auch als Zinnstein oder Kassiterit bezeichnet), vor. Zur Gewinnung wird Zinnstein zerkleinert und dann durch verschiedene Verfahren (Aufschlämmen, elektrische/magnetische Scheidung) angereichert. Nach der Reduktion mit Kohlenstoff wird das Zinn knapp über seine Schmelztemperatur erhitzt, so dass es ohne höher schmelzende Verunreinigungen abfließen kann

Aus den oben genannten gründen weisen Werkstücke aus leicht oxidierbaren Nichteisenmetallen als auch Werkstücke aus deren Legierungen - wenn sie unbehandelt sind - stets eine oxidierte Oberflächenschicht, beispielsweise aus Magnesiumoxid, auf, die durch spontane Oxidation mit dem Luftsauerstoff entsteht.

Werden Werkstücke aus leicht oxidierbaren Nichteisenmetallen nicht vor dem Luftsauerstoff geschützt, oxidieren sie z.T. innerhalb kurzer Zeit auch in die Tiefe, was in seinen Folgen der Korrosion bei Stahl gleichzusetzen ist - allerdings erfolgt dieser Prozess mit sehr viel höherer Geschwindigkeit, und er wird insbesondere durch Feuchtigkeit noch unterstützt. Letzteres gilt z.B. insbesondere für Werkstücke aus Magnesium bzw. aus Magnesiumlegierungen

Daher müssen Werkstücke aus leicht oxidierbaren Nichteisenmetallen an ihrer Oberfläche so behandelt werden, dass sie vor dem Einfluß von Luftsauerstoff geschützt werden. In der Technik sind dafür verschiedene Methoden bekannt

Insbesondere im Automobilbau, wo Leichtmetalle aufgrund ihres günstigen Verhältnisses aus Festigkeit und spezifischer Dichte sehr begehrt sind, werden die in bekannter Weise lackiert, so z.B. durch Tauchlackierung, Spritzlackierung oder Pulverlackierung. Dieses an sich sehr bewährte Vorgehen weist jedoch den Nachteil auf, dass Lacke nur eine geringe Widerstandsfähigkeit gegen harte Stöße aufweisen und zum Abplatzen neigen. Wird jedoch die Lackschicht an einer Stelle unterbrochen, und das Werkstück oder der Werkstoff kommt in Kontakt mit dem Luftsauerstoff, wird letzteres bzw. letzterer an dieser Stelle sofort oxidiert, und es kann sich ein Oxidationskeim entwickeln, der auch durch späteres Überlackieren nicht wieder in den Griff zu bekommen ist. Dies kann zur Folge haben, dass das Werkstück ausgetauscht werden muß - falls überhaupt möglich.

Weiterhin ist die galvanische Beschichtung von Werkstücken aus leicht oxidierbaren Nichteisenmetallen bekannt. Diese verbessern zwar die Korrosionseigenschaften, haften jedoch auf den Werkstücken häufig nicht ausreichend, und weisen überdies eine geringe mechanische Widerstandsfähigkeit auf.

Ferner können Werkstücke aus leicht oxidierbaren Nichteisenmetallen mittels elektrolytischen Beschichtungsverfahren mit einer Oxidkeramikschicht versehen werden. Dabei wird eine äußere Stromquelle verwendet, gegen welche das zu beschichtende Werkstück als Anode geschaltet wird. Als Elektrolyt wird eine Salzlösung verwendet.

Die sogenannte Anodisation erfolgt über Plasmaentladungen im Elektrolyten an der Oberfläche des zu beschichtenden Werkstücks. Die Schicht besteht aus einer kristallinen Oxidkeramik, die zur Hälfte in den Magnesiumwerkstoff hineinwächst und einen hohen Anteil sehr resistenter Verbindungen wie Spinelle, z. B. MgAl₂O₄ enthält. Kanten, Hohlräume und Reliefs werden gleichmäßig beschichtet, d. h. es findet kein Kantenaufbau wie bei galvanischen Verfahren statt.

Thermische Beschichtungsverfahren von Werkstücken aus leicht oxidierbaren Nichteisenmetallen umfassen das Hochgeschwindigkeitsflammspritzen, das atmosphärische Plasmaspritzen und das Lichtbogenspritzen. Durch den Einsatz dieser Verfahren können im Allgemeinen gut haftende Verschleißschutzschichten erzielt werden.

Ein explizites Verfahren nennt zum Beispiel die EP 0 483 839 A1. In diesem Patentdokument wird ein Verfahren zur Reinigung von Metalloberflächen und eine anschließende Beschichtung beschrieben. Das Verfahren ist dadurch gekennzeichnet, dass die Metalloberflächen (Substrate) durch ein mittels Mikrowellen angeregtes Plasma mit Sauerstoff und Wasserstoff als Arbeitsgas im Wechsel mit mindestens einmaligem Wechsel gereinigt werden und anschliessend die Beschichtung durch eine physikalische Dampfphasenabscheidung (PVD) oder eine plasmaaktivierte chemische Dampfphasenabscheidung (PECVD) ausgeführt wird.

Allen genannten Verfahren ist jedoch gemein, dass die erzielten Beschichtungen zwar im Rahmen gewisser Grenzen eine Korrosion bzw. Oxidation des Werkstücks verhindern, jedoch in Bezug auf Haftung und/oder mechanische Widerstandskraft nicht höchsten Ansprüchen genügen, d.h. unter bestimmten Bedingungen delaminieren, abplatzen oder beschädigt werden können, und so das beschichtete Werkstock der Oxidation bzw. der Korrosion preisgeben.

Aus diesem Grund sind die genannten Verfahren für verschiedene anspruchsvolle Einsatzgebiete, wie z.B. Automotive, Flugzeugbau, Hydrauliktechnik, Chirurgie, Werkzeugbau oder Weltraumtechnik nicht geeignet.

So wurde z.B. berichtet, dass lackierte Magnesiumwerkstücke, wie sie bereits im Automobilbau verwendet werden, nach einem Lackabplatzer, der z.B. bei Einparkmanövern leicht entstehen kann, komplett ausgetauscht werden müssen, da selbst bei sofortiger Lackreparatur die kurze Zeit, binnen welcher das Magnesiumwerkstück an besagter Stelle ungeschützt dem atmosphärischen Sauerstoff ausgesetzt war, einen Korrosionsprozess auszulösen, der letztlich das gesamte Werkstück unaufhaltbar zerstört.

### Aufgabe der vorliegenden Erfindung

Aufgabe der vorliegenden Erfindung ist es daher, ein Verfahren zur Beschichtung von Werkstücken und/oder Werkstoffen aufweisend mindestens ein leicht oxidierbares Nichteisenmetall oder eine Legierung aufweisend leicht oxidierbare Nichteisenmetalle bereitzustellen, wobei die Beschichtung bessere Hafteigenschaften aufweist als die aus dem Stand der Technik bekannten Verfahren.

Weitere Aufgabe ist es, ein Verfahren zur Beschichtung von Werkstücken und/oder Werkstoffen aufweisend mindestens ein leicht oxidierbares Nichteisenmetall oder eine Legierung aufweisend leicht oxidierbare Nichteisenmetalle bereitzustellen, wobei die Beschichtung eine bessere mechanische Widerstandskraft aufweist als die aus dem Stand der Technik bekannten Verfahren.

Weitere Aufgabe ist es, ein Verfahren zur Beschichtung von Werkstücken und/oder Werkstoffen aufweisend mindestens ein Erdalkalimetall ein leicht oxidierbares Nichteisenmetall oder eine Legierung aufweisend leicht oxidierbare Nichteisenmetalle bereitzustellen, das sich für die Beschichtung von hochbelasteten Werkstücken eignet.

Diese Aufgaben werden mit den Merkmalen des vorliegenden Hauptanspruchs gelöst.

### Beschreibung der bevorzugten Ausführungsformen

Demnach ist ein Verfahren zum Aufbringen einer Beschichtung auf Werkstücke und/oder Werkstoffe aufweisend mindestens ein leicht oxidierbares Nichteisenmetall oder eine Legierung aufweisend mindestens ein mindestens ein leicht oxidierbares Nichteisenmetall, das Verfahren aufweisend die folgenden Schritte:
b) Vorbehandlung des Werkstücks und/oder Werkstoffs mittels Plasmareduktion
c) Aufbringen einer Deckschicht durch Plasmabeschichtung in einer Plasmabeschichtungskammer.

Der Begriff "Plasmabeschichtung" (PECVD "Plasma Enhanced Chemical Vapor Deoposition") bezeichnet ein Verfahren zum Aufbringen von Beschichtungen auf Werkstücke und/oder Werkstoffe

Der Begriff "Plasmareduktion", wie vorliegend verwendet, bezieht sich auf ein in einer Plasmabeschichtungskammer durchgeführte Verfahren, bei welchem den an der Oberfläche des Werkstücks und/oder Werkstoffs vorliegenden Oxiden (i.d.R. Metalloxiden) der Sauerstoff entzogen wird. Die Metalloxide werden so zu ihrer elementaren Metallform reduziert. Daher nennt man einen solchen Schritt auch "Metallisierung".

Bevorzugt ist vorgesehen, dass es sich bei dem leicht oxidierbaren Nichteisenmetall oder seiner Legierung um Magnesium bzw. eine Magnesiumlegierung handelt.

Ferner ist bevorzugt vorgesehen, dass das Reaktionsgas in Schritt b) mindestens Wasserstoff aufweist. Letzterer kann in einer Mischung mit Argon verwendet werden.

Im Falle, dass es sich bei dem leicht oxidierbaren Nichteisenmetall um Magnesium handelt, gehorcht der Prozess vorliegendem Schema:

MgO + 2 [H] -----> Mg + H₂O (ggf. in Anwesenheit von Argon)

Argon als optionale Komponente nimmt dabei an der Reaktion nicht teil.

Für andere leicht oxidierbare Nichteisenmetalle gelten z.B. folgende Schemata:

Al₂O₃ + 6 [H] -----> 2 Al + 3 H₂O (ggf. in Anwesenheit von Argon)

ZnO + 2 [H] -----> Zn + H₂O (ggf. in Anwesenheit von Argon)

BeO + 2 [H] -----> Be + H₂O (ggf. in Anwesenheit von Argon)

TiOx + X [H] -----> Ti + X H₂O (ggf. in Anwesenheit von Argon)

Das Verfahren der Plasmareduktion weist gegenüber anderen Verfahren zur Oberflächenreduktion die Vorteile auf, dass
a) das Verfahren in ein- und derselben Vorrichtung wie die nachfolgende Plasmabeschichtung durchgeführt werden kann, und
b) dass das Verfahren bei niedrigen Temperaturen durchgeführt werden kann

So sind z.B. Verfahren zur Oberflächenreduktion/Metallisierung von Ferriten bekannt, bei welchen das Werkstück und/oder der Werkstoff wärmebehandelt und mit einem gasförmigen Reduktionsmittel, wie z.B. Wasserstoff, Ammoniak (oder Mischungen derselben mit Stickstoff oder Edelgasen) in Kontakt gebracht wird. Bei der anschließenden Wärmebehandlung in einer Wärmekammer werden Temperaturen zwischen 600 °C und 800 °C verwendet, um die Oberflächenoxide vollständig zu ihrer Metall form zu reduzieren. Für die Behandlung von Erdalkalimetallen eignet sich dieses Verfahren jedoch nicht, denn Magnesium hat z.B. bei Normaldruck eine Schmelztemperatur von 650 °C, im Vakuum je nach Legierung sogar 180 °C.

Ferner ist bevorzugt vorgesehen, dass in Schritt b) der Zufluß des Reaktionsgases periodisch moduliert wird.

Wir bereits erwähnt kommt als Reaktionsgas hier bevorzugt Wasserstoffgas zum Einsatz. Durch die periodische Modulation kann nun erreicht werden, dass zu bestimmten Phasen viel Reaktionsgas in die Kammer strömt, während zu anderen Phasen nur wenig Reaktionsgas in die Kammer strömt.

Die Modulation des Reaktionsgases kann beispielsweise mit einem prozessorgesteuerten Mass Flow Controller (MFC) oder mit einem prozessorgesteuerten servoünterstützten Ventil erfolgen. Die Modulation kann z.B. sinusförmig, aber auch rechteck- oder dreieckförmig erfolgen.

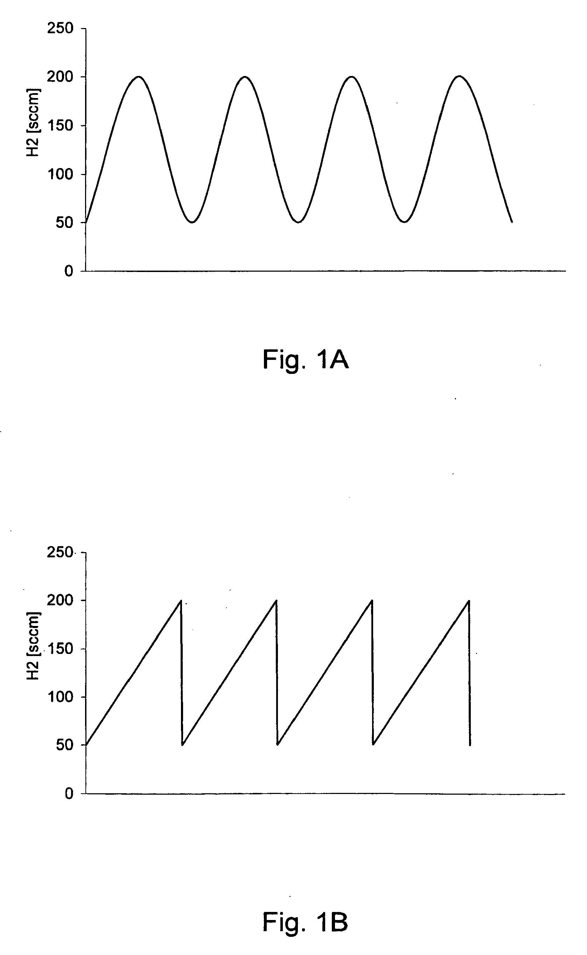

Dabei kann der Zufluss, der in der Einheit Standardkubikzentimeter min⁻¹ (sccm) gemessen wird bevorzugt in einem Bereich zwischen ≥ 10 und ≤ 1000 sccm, besonders bevorzugt zwischen ≥ 50 und ≤ 300 sccm, moduliert werden. Siehe hierzu auch Fig. 1.

Durch die periodische Modulation des Reaktionsgas-Zuflusses wird der zerklüfteten Oberfläche des Werkstücks und/oder Werkstoffs Rechnung getragen, denn nur so gelingt es, sowohl in tiefen Riefen und Mikrokavitäten der Oberfläche des Werkstücks und/oder Werkstoffs vorhandene Metalloxidreste als auch an flachen Passagen der Oberfläche anhaftende Metalloxidreste ausreichend gründlich zu reduzieren.

Für die an flachen Passagen der Oberfläche anhaftenden Metalloxidreste sind hohe Zuflussraten ideal, da auf diese weise eine schnelle Metallisierung dieser leicht erreichbaren Passagen möglich ist.

Wesentlich ist hingegen, dass insbesondere die in tiefen Riefen der Oberfläche des Werkstücks und/oder Werkstoffs vorhandene Metalloxidreste nur dann in Kontakt mit dem ionisierten Reaktionsgas kommen, wenn dieses mit geringen Zuflussraten in die Kammer einströmt, während die an flachen Passagen der Oberfläche anhaftenden Metalloxidreste größere Zuflussraten verlangen, um ausreichend schnell reduziert zu werden.

Ursache hierfür ist, dass bei geringen Gaskonzentrationen (also geringen Zuflussraten) die Gasionen im Plasma sehr viel stärker beschleunigt werden können als bei höheren Gaskonzentrationen (also hohen Zuflussraten). Dies hat den Grund, dass bei geringen Gaskonzentrationen die Gasionen sehr viel seltener miteinander kollidieren und sich somit weniger stark abbremsen als bei höheren Gaskonzentrationen.

Aus diesem Grunde hat auch die durch das Wechselfeld erzeugte Ionenschwingung bei geringen Gaskonzentrationen eine sehr viel größere Amplitude bei höheren Gaskonzentrationen.

Die größere Geschwindigkeit der Gasionen, verbunden mit einer größeren Schwingungsamplitude, sorgt dafür, dass auch in tiefen Riefen und Mikrokavitäten der Oberfläche des Werkstücks und/oder Werkstoffs vorhandene Metalloxidreste ausreichend gründlich reduziert werden können.

Bei gleich bleibender Anregungsfrequenz führt also die periodische Modulation des Reaktionsgas-Zuflusses zu einer sich periodisch ändernden Geschwindigkeit und Schwingungsamplitude der Gasionen.

Es kann vorkommen, dass die an der Oberfläche vorgefundene Metalloxidschicht so stark ist, dass sie durch Plasmareduktion nicht vollständig metallisiert werden kann. In einer bevorzugten Ausgestaltung des erfindungsgemäßen Verfahrens weist das Verfahren vor Schritt b) daher mindestens einen Schritt

### a.2) Aktivieren des Werkstücks und/oder des Werkstoffs durch Sputtern. auf.

Der Begriff "Aktivieren", wie vorliegend verwendet, bezieht sich auf das aktive Entfernen bzw. Abtragen einer an der Oberfläche des Werkstücks und/oder des Werkstoffs vorliegenden Verunreinigung, insbesondere einer Metalloxid-Schicht.

Der Begriff "Sputtern" oder "Sputterätzen", wie vorliegend verwendet, bezeichnet einen physikalischen Vorgang, bei dem Atome aus einem Festkörper durch Beschuss mit energiereichen Ionen herausgelöst werden und in die Gasphase übergehen. Diese Ionen werden - ähnlich wie beim PECVD - durch Erzeugung eines Plasmas mittels eines hochfrequenten elektromagnetischen Wechselfeldes in einer Vakuumkammer erzeugt. Als Reaktionsgas kommen hier in der Regel Edelgase in Frage, wie zum Beispiel Argon (Ar₂), die - mit Ausnahme von Helium und Neon - Aufgrund ihres hohen Molekulargewichts eine hohe kinetische Energie aufweisen und so besonders gut für einen effizienten Oberflächenabtrag geeignet sind.

Im Prinzip stellt zwar O₂ ein attraktives Reaktionsgas für das Sputtern dar, da die ionisierten Sauerstoffatome ebenfalls ein hohes Molekulargewicht aufweisen. Zudem ist Sauerstoff sehr billig. Für das Sputtern eines erdalkalimetallhaltigen Werkstoffs oder Werkstück als Vorbehandlung bzw. Aktivierung für eine späterer Weiterbehandlung kann jedoch kein O₂ verwendet werden, da dies oxidierend auf die metallische Oberfläche wirkt, dort eine mehr oder minder dicke Metalloxid-Schicht bildet und so die Oberfläche passiviert - also das Gegenteil von dem bewirken, was für das erfindungsgemäße Verfahren wünschenswert ist.

Hier wäre eigentlich ein reduzierend wirkendes Gas wie z.B. H₂, ideal da dies eine solche Passivierung der Metalloberfläche ebenfalls verhindern bzw. sogar rückgängig machen könnte Aufgrund seines geringen Molekulargewichts und damit verbundener geringer kinetischer Energien ist H₂ jedoch für das Sputtern nicht geeignet.

Aus diesem Grunde kommt erfindungsgemäß bevorzugt ein nicht reaktives Edelgas aus der achten Hauptgruppe des Periodensystems zum Einsatz, und hier bevorzugt Argon. Das erwähnte reduzierend wirkende Gas Wasserstoff kommt erfindungsgemäß hingegen erst in Schritt b) zum Einsatz, also zur Plasmareduktion. Die Schritte der Aktivierung (also der Abtragung von Oberflächenverunreinigungen, insbesondere Metalloxiden) und der Metallisierung (also der Reduktion verbliebener Metalloxidreste) finden also arbeitsteilig statt, wobei der erste Schritt mit Argon durchgeführt wird, während der zweite Schritt mit Wasserstoff durchgeführt wird.

Es muß, wie oben angedeutet, davon ausgegangen werden, dass der Verfahrensschritt der Aktivierung nicht so gründlich ist, dass er sämtliches Metalloxid an der Oberfläche stets vollständig entfernt. Es bleiben also häufig Reste an Metalloxid zurück, die gleichwohl beseitigt werden müssen, um eine spätere Nachoxidierung des Werkstücks und/oder Werkstoffs zu verhindern. Daher bleibt Schritt b) (Plasmareduktion) gemäß Hauptanspruch der vorliegenden Erfindung auch bei einem zuvor durchgeführten Sputterschritt weiterhin erforderlich. Es sei darauf hingewiesen, dass es sich beim Sputtern um ein abtragendes Verfahren handelt (d.h. Metalloxide werden entfernt), während des sich bei der Plasmareduktion um ein umwandelndes Verfahren handelt (d.h. Metalloxide werden zu Ihrer Elementarform reduziert).

Besonders vorteilhaft ist, dass sich der Schritt des Sputterns und der Schritt der Plasmareduktion in derselben Vorrichtung, nämlich einer Plasmabeschichtungskammer, durchführen lassen. Daher kann während und zwischen beiden Schritten ein kontinuierliches Vakuum gewährleistet werden, was die spontane Neubildung von Metalloxiden an der Oberfläche des Werkstücks und/oder Werkstoffs zwischen beiden Verfahrensschritten unterbindet. Überdies wird so der Verfahrensaufwand erheblich reduziert und das Verfahren ökonomisch konkurrenzfähig.

Da zum Sputtern bevorzugt Argon verwendet wird und bei der Plasmareduktion neben H₂ auch Argon verwendet werden kann, können die Schritte a.2) und b) auch stufenlos ineinander übergehen. Hierbei wird nach dem Sputterschritt mittels der unten beschriebenen "Rampen" die Gaszufuhr von H₂ allmählich heraufgefahren, während die Gaszufuhr von Argon ggf. heruntergefahren wird. Gleichzeitig werden die Verfahrensparameter (insbesondere die Biasspannung), falls erforderlich, entsprechend stufenlos oder abrupt angepasst.

Vor diesem Hintergrund erscheint eine bevorzugte Ausführungsform des erfindungsgemäßen Verfahrens besonders logisch, in welcher der Schritt

### a.2) Aktivieren des Werkstücks und/oder des Werkstoffs durch Sputtern.

zeitgleich mit Schritt b) durchgeführt wird. Dies insbesondere deswegen sinnvoll, weil (i) beim Sputtern mit Argon eventuell vorhandener Wasserstoff nicht stört, und (ii) bei der Plasmareduktion mit Wasserstoff ohnehin Argon verwendet werden kann.

Bevorzugt findet das Sputtern unter Verwendung der folgenden Verfahrensparameterbereiche statt:

**Tabelle 2**

| **Parameter** | **Generell** | **Bevorzugt** | **Besonders bevorzugt** |
|---|---|---|---|
| Reaktionsgas | Edelgas aus der achten Hauptgruppe | Ar₂ | Ar₂ |
| Biasspannung (V) | ≥ 100 und ≤ 500 | ≥ 200 und ≤ 400 | ≥ 300 und ≤ 350 |
| Kammerdruck (P) | ≥ 0,001 und ≤ 4 | ≥ 0,001 und ≤ 1 | ≥ 0,001 und ≤ 0,5 |
| Temperatur in der Kammer (°C) | ≥ 30 und ≤ 200 | ≥ 30 und ≤ 100 | ≥ 30 und ≤ 50 |
| Gasfluss (sccm) | ≥ 20 und ≤ 500 | ≥ 20 und ≤ 300 | ≥ 20 und ≤ 100 |

Weiterhin ist bevorzugt vorgesehen, dass das erfindungsgemäße Verfahren vor Schritt b) mindestens einen Schritt
a.1) Behandlung der Oberfläche des Werkstücks und/oder Werkstoffs durch mindestens ein abrasives Verfahren
aufweist.

Elementare Erdalkalimetalle, insbesondere Magnesium, sind, auch wenn sie in Legierungen vorliegen, außerordentlich reaktiv. Werkstücke bzw. Werkstoffe, die dem Luftsauerstoff ausgesetzt sind, bilden daher sehr schnell eine sehr dicke Oxidschicht. Es empfiehlt sich daher in einigen Fällen, diese Oxidschicht zunächst mechanisch-abrasiv abzutragen, bevor die Werkstücke bzw. Werkstoffe dem oben geschilderten Sputterschritt unterzogen werden.

Bevorzugt handelt es sich bei dem abrasiven Verfahren um mindestens ein Verfahren ausgewählt aus der Gruppe enthaltend
- Schleifen
- Sandstrahlen
- Kugelstrahlen
- Bürsten, und/oder
- Polieren.

Bevorzugt werden jedes einzelne dieser Verfahren im Trockenen ausgeführt, da die Gefahr besteht, dass bei Durchführung in Gegenwart von Wasser die Oxidation der Materialoberfläche gefördert wird.

Dieser Schritt ist insbesondere deswegen sinnvoll, da die Abtragungsrate bei abrasiven Verfahren sehr viel höher sein kann als beim Sputtern (< 2 µm h⁻¹ beim Sputtern vs. > 1 mm h⁻¹ z.B. beim Sandstrahlen).

Gleichwohl handelt es sich bei diesem Schritt um einen optionalen Schritt, der einerseits bei nicht sehr stark oxidierten Werkstücken bzw. Werkstoffen nicht zwingend erforderlich ist, und andererseits den Sputterschritt nicht ersetzen kann.

Letzteres ist insbesondere deswegen der Fall, da sich unmittelbar nach der abrasiven Behandlung, die in aller Regel unter atmosphärischen Bedingungen stattfindet, spontan neues Metalloxid an der Oberfläche der Werkstücke bzw. Werkstoffe bildet. Eine Kombination eines abrasiven Verfahrensschritts mit dem Plasmareduktionsschritt in ein- und derselben Vorrichtung ist hingegen aus technischen Gründen nicht sinnvoll.

Besonderes bevorzugt ist vorgesehen, dass es sich bei dem leicht oxidierbaren Nichteisenmetall um mindestens ein Metall ausgewählt aus der Gruppe enthaltend Zinn, Zink, Titan, Aluminium, Beryllium, und/oder Magnesium oder eine Magnesiumlegierung handelt. Dabei kann das besagte mindestens eine Nichteisenmetall auch in einer Legierung vorkommen. Die folgende Tabelle zeigt eine nicht beschränkende beispielhafte Auswahl bevorzugter Magnesiumlegierungen, sowie die ASTM-Kurzbezeichnungen für die Legierungselemente des Magnesiums.

**Tabelle 3**

| **Legierung** | **Zusammensetzung** | **Kurzbuchstabe** | **Legierungselement** |
|---|---|---|---|
| AZ91 | (Aluminium/Zink 9 % : 1 %) | A | Aluminium |
| AZ91D | | B | Bismut |
| AZ91Ca | | C | Kupfer |
| AZ81 | | D | Cadmium |
| AZ80 | | E | Seltene Erden |
| AM60 | (Aluminium/Mangan 6 % : < 1 %) | F | Eisen |
| AM50 | | H | Thorium |
| AM30 | | K | Zirkonium |
| AZ63 | | L | Lithium |
| AZ61A | | M | Mangan |
| AJ62A | | N | Nickel |
| AE44 | | P | Blei |
| AE42 | | Q | Silber |
| AZ31B | | R | Chrom |
| AS41 | | S | Silizium |
| AS21 | | T | Zinn |
| WE43 | | W | Yttrium |
| ZE41 | | Y | Antimon |
| A6 | | Z | Zink |
| ZK60A | | | |

Weitere bevorzugt verwendete Legierungen sind in der folgenden Tabelle aufgeführt:

**Tabelle 4**

| **Legierung** | **Zusammensetzung** |
|---|---|
| Albemet | 62 % Be, 38 % Al |
| Berylliumkupfer | 0,4 bis 2 % Be, 0 bis 2,7 Co, Rest Cu |
| Messing | Zn/Cu, Cu-Gehalt stets ≥ 50 Gew. -% |
| Bronze | Sn/Cu, Sn-Gehalt stets ≤ 40 Gew.-% |

Bevorzugt findet die Plasmareduktion unter Verwendung der folgenden Verfahrensparameterbereiche statt:

**Tabelle 5**

| **Parameter** | **Generell** | **Bevorzugt** | **Besonders bevorzugt** |
|---|---|---|---|
| Reaktionsgas | H₂, ggf beaufschlagt mit Ar₂ | | |
| Biasspannung (V) | ≥ 100 und ≤ 500 | ≥ 200 und ≤ 400 | ≥ 300 und ≤ 350 |
| Kammerdruck (P) | ≥ 0,001 und ≤ 4 | ≥ 0,001 und ≤ 1 | ≥ 0,001 und ≤ 0,5 |
| Temperatur in der Kammer (°C) | ≥ 30 und ≤ 200 | ≥ 30 und ≤ 100 | ≥ 30 und ≤ 50 |
| Gasfluss (sccm) | ≥ 20 und ≤ 500 | ≥ 20 und ≤ 300 | ≥ 20 und ≤ 100 |
| Frequenz des elektromagnetischen Wechselfeldes | 13,37 MHz | 13,37 MHz | 13,37 MHz |
| Anzahl der Zyklen der periodischen Modulation | >10 | >40 | >60 |
| Dauer eines Zyklus der periodischen Modulation (s) | > 100 | > 200 | > 500 |

Ebenso ist bevorzugt vorgesehen, dass es sich bei der Deckschicht um eine Schicht ausgewählt aus der Gruppe enthaltend
- Kohlenstoffhaltige Schichten
- Siliziumhaltige Schichten
- Titanhaltige Schichten
- Wolframhaltige Schichten
- Wolframcarbidhaltige Schichten
- Vanadiumhaltige Schichten, und/oder
- Kupferhaltige Schichten.
handelt.

Wie bereits eingangs erwähnt, wird gemäß der vorliegenden Erfindung die hochfeste Deckschicht durch Plasmabeschichtung aufgebracht. Hierbei wird neben einem inerten Schutzgas ein Reaktionsgas verwendet.

Als Reaktionsgas für die Herstellung einer kohlenstoffhaltigen Beschichtung, wie z.B. DLC ("Diamond Like Carbon"), die häufig diamantähnliche Eigenschaften und Strukturen aufweist da die Kohlenstoffatome überwiegend als sp3-Hybride vorliegen, kommen insbesondere Methan (CH₄), Ethen (C₂H₄), oder Acetylen (C₂H₂) zum Einsatz.

Als Reaktionsgase für die Abscheidung einer Siliziumhaltigen Schicht kommen beispielsweise Methyl-Trichlor-Silan (CH₃SiCl₃), Tetramethylsilan (TMS) oder Tetramethyldisiloxan (C₄H₁₄OSi₂) zum Einsatz.

Eine Siliciumnitrid-Schicht als Deckschicht wird hingegen unter Verwendung der Reaktionsgase Ammoniak und Dichlorsilan erzeugt. Für Siliciumdioxid-Schichten werden die Reaktionsgase Silan und Sauerstoff verwendet. Solche Schichten sind ebenfalls besonders bevorzugte Ausgestaltungen der Erfindung.

Zur Herstellung von Metall/Silicium-Hybriden (Siliciden) als Deckschicht oder wolframhaltigen Deckschichten wird als Reaktionsgas z.B. Wolframhexafluorid (WF₆) oder Wolfram IV chlorid (WCl₄) eingesetzt.

Titannitrid-Schichten als Deckschicht zum Härten von Werkzeugen werden aus TDMAT (Tetrakis-Dimethyl-Amido-Titanium) und Stickstoff erzeugt. Siliciumcarbid-Schichten werden aus einem Gemisch aus Wasserstoff und Methyl-Trichlor-Silan (CH₃SiCl₃) abgeschieden.

Zur Abscheidung einer kupferhaltigen Deckschicht werden insbesondere Kupfer (II) hexafluoroacetylacetonat-hydrat, Kupfer (II) 2-ethylhexanoat und Kupfer (II) fluorid (wasserfrei) eingesetzt.

Zur Abscheidung einer vanadiumhaltigen Deckschicht wird insbesondere Vanadium (V) tri-i-propoxyoxide (C₉H₂₁O₄V) eingesetzt.

Grundsätzlich ist für ein Abscheiden aus der Gasphase erforderlich, dass das abzuscheidende Material in Gasform für das Verfahren verfügbar gemacht werden kann ("Reaktionsgas").

Wie bereits dargestellt liegen in obigen Fällen Abscheidungsmedien in gasförmigem Aggregatzustand vor; diese können daher als Reaktionsgase für die Beschichtung ohne weitere Modifikationen verwendet werden.

Es besteht jedoch ein erheblicher Bedarf an Beschichtungen, die nicht oder nicht ausschließlich aus Kohlenstoff und/oder Silikaten aufgebaut sind. Hier wären z.B. Halbleitermetalle zu nennen, die in dünnen Schichten auf ein Trägermaterial aufgebracht besondere Eigenschaften entfalten. Für diese Materialien stehen in der Regel keine bei Raumtemperatur gasförmigen Precursor, d.h. keine das betreffende Material aufweisenden und/oder verfügbar machenden Reaktionsgase zur Verfügung.

Ferner sind Metalle wie Titan zu nennen, die - ähnlich wie DLC - über besonders hohe Festigkeiten verfügen.

Hierzu kommen bei Raumtemperatur in Gasform vorliegende bzw. flüssige, leicht flüchtige Materialien in Frage. Aus der DE 10 2007 020 852 des Anmelders der vorliegenden Erfindung ist erstmals eine Vorrichtung bekannt, mittels welcher bei Raumtemperatur in fester oder flüssiger Form vorliegende Materialien (wie z.B. C₁₂H₂₈O₄Ti) für das Abscheiden aus der Gasphase verfügbar gemacht werden kann, um auf diese Weise Kohlenstoff- und/oder Siliziumoxide funktionell zu dotieren oder aber Reinbeschichtungen auf Basis der besagten Feststoffe zu erzeugen.

Dies erfolgt mithilfe eines Gasversorgungssystems für eine Gasphasenabscheidungs-Reaktionskammer mit einer Gasversorgungseinrichtung, wobei die Gasversorgungseinrichtung mindestens ein Heizelement zum Erwärmen eines bei Raumtemperatur festen oder flüssigen Abscheidungsmediums und zur Überführung des Abscheidungsmediums in die Gasphase aufweist. Ferner weist das System eine Gaszufuhreinrichtung zum Transport des in die Gasphase überführen Abscheidungsmediums von der Gasversorgungseinrichtung in die Gasphasenabscheidungs-Reaktionskammer auf. Auf den Inhalt besagter Anmeldung wird hier vollumfänglich Bezug genommen.

Der Offenbarungsgehalt der DE 10 2007 020 852 soll als der vorliegenden Anmeldung vollumfänglich hinzugefügt gelten.

Demnach ist in einer bevorzugten Ausgestaltung des erfindungsgemäßen Verfahrens vorgesehen, dass ein fester oder flüssiger Precursor für ein Reaktionsgas in einem der Plasmabeschichtungskammer vorgeschalteten Gasversorgungssystem erhitzt und unter Vakuum in die Dampfphase gebracht und anschließend über eine Gaszufuhreinrichtung in die Plasmabeschichtungskammer eingespeist wird.

Dabei ist das System thermisch so eingerichtet - durch kontinuierliche thermische Isolierung sowie durch stetige Temperierung - dass der in die Dampfphase gebrachte Precursor in der Gaszufuhreinrichtung nicht rekondensieren kann.

Als Ventile zur Steuerung des Gasflusses kommen bevorzugt Nadelventile zum Einsatz, Diese weisen im Vergleich zu Mass-Flow-Controllern (MFC) erhebliche Vorteile auf. So sind Mass Flow Controller nicht in der Lage, über den gesamten von Ihnen belegten Gasweg konstante Temperaturen zu gewährleisten. Dies kann zum Auskondensieren von verdampftem Precursor führen. Dabei besteht die Gefahr, dass der Mass-Flow-Controller verstopft und funktionsuntüchtig wird. Hinzu kommt, dass das ein Nadelventil äußerst hitzebeständig ausgeführt sein kann, so dass es Temperaturen bis 600 °C übersteht, anders als ein MFC, der diese Temperaturen nicht übersteht. Dies kann vorteilhaft sein bei Abscheidungsmedien, die im erfindungsgemäßen Gasversorgungssystem auf sehr hohe Temperaturen erhitzt werden müssen, um in die Gasphase überzugehen.

Vorteile einer solchen Einrichtung sind in der WO2008135516 beschrieben, die auf denselben Erfinder wie die vorliegende Erfindung zurückgeht, und deren Offenbarungsgehalt dem der vorliegenden Anmeldung als zugefügt gelten soll.

Als Precursor kommen u.a. die in der folgenden Tabelle aufgelisteten Medien in Frage:

**Tabelle 6**

| **Material** | **Hauptgruppe des Periodensystems der Elemente** | **Precursor (Beispiel)** | **Aggregatzustand bei Raumtemperatur** |
|---|---|---|---|
| Ti | III | C₁₂H₂₈O₄Ti | fest |
| Ti | III | Ti[OCH(CH₃)₂]₄. | fest |
| Si | IVA | O[Si(CH₃)₃]₂ | fest |
| Ga | III | C₁₅H₂₁GaO₆ | fest |
| In | III | C₁₅H₂₁InO₆ | fest |
| Mo | VIB | C₆O₆Mo | fest |
| Cu | IB | C₁₀H₂CuF₁₂O₄ | fest |
| Cu | IB | C₁₀H₁₄CuO₄ | fest |
| Se | VIA | C₆H₅SeH | fest |
| Cd | IIB | (Cd(SC(S)N(C₂H₅)₂]₄) | fest |
| Zn | IIB | Zn(C₅H₇O₂)₂ | fest |
| Sn | IVA | C₈H₂₀Sn | flüssig |

Ferner ist erfindungsgemäß vorgesehen, dass zwischen Schritt b) und Schritt c) der Schritt b.1) Aufbringen einer Haftschicht mittels Plasmabeschichtung erfolgt.

Die erfindungsgemäße Haftschicht trägt auf verschiedenerlei Weise zu einer verbesserten Haftung der Deckschicht auf dem Werkstück bzw. Werkstoff bei. So
- gleicht sie Unebenheiten der Werkstoffoberfläche aus
- weist sie idealerweise eine intermediäre Eigenspannung auf, also eine Eigenspannung, die zwischen der des Werkstoffs und der des Materials der Decksicht liegt
- wird die Zwischenschicht mit der Eigenspannung verquer zur Eigenspannung des Materials, also des Substrates aufgebracht und hat dadurch eine ausgleichende Wirkung.

Besonders bevorzugt ist vorgesehen, dass die Haftschicht Elemente aus der 6. und 7. Nebengruppe aufweist.

Bevorzugt werden hier Verbindungen verwendet, die die Elemente Cr, Mo, W, Mn, Mg, Ti und oder Si, und insbesondere Gemische derselben, enthalten. Ebenso können sich die einzelnen Bestandteile gradiert über die Tiefe der Haftschicht verteilen. Insbesondere bevorzugt ist hierbei Si. Als Reaktionsgas kommt hier z.B. das unter Vakuumbedingungen leicht flüchtige TMS in Frage.

In weiteren bevorzugten Ausführungsformen des erfindungsgemäßen Verfahrens ist vorgesehen, dass die Gaszufuhr mindestens zwei verschiedener Gase
- in Schritt a.2),
- beim Übergang von Schritt a.2) nach Schritt b)
- beim Übergang von Schritt b) nach Schritt b.1) oder Schritt c)
- beim Übergang von Schritt b.1) nach Schritt c)

in Form von gegenläufigen Rampen erfolgt. Um das besagte Prinzip zu erläutern, werden in der folgenden Tabelle die erfindungsgemäß vorgesehenen, z.T. optionalen Verfahrensschritte aufgeführt.

**Tabelle 7**

| **Schritt** | **Status** | **Inhalt** | **Reaktionsgas/Methode (Beispiel)** |
|---|---|---|---|
| a.1) | optional/bevorzugt | Behandlung der Oberfläche des Werkstücks und/oder Werkstoffs durch mindestens ein abrasives Verfahren | Sandstrahlen |
| a.2) | optional/bevorzugt | Aktivieren des Werkstücks und/oder des Werkstoffs durch Sputtern | Ar₂ |
| b) | obligatorisch | Vorbehandlung des Werkstücks und/oder Werkstoffs mittels Plasmareduktion | H₂ |
| b.1) | optional/bevorzugt | Aufbringen einer Haftschicht mittels Plasmabeschichtung, | TMS |
| c) | obligatorisch | Aufbringen einer Deckschicht durch Plasmabeschichtung in einer Plasmabeschichtungskammer. | C₂H₂ oder C₄H₁₄OSi₂ |

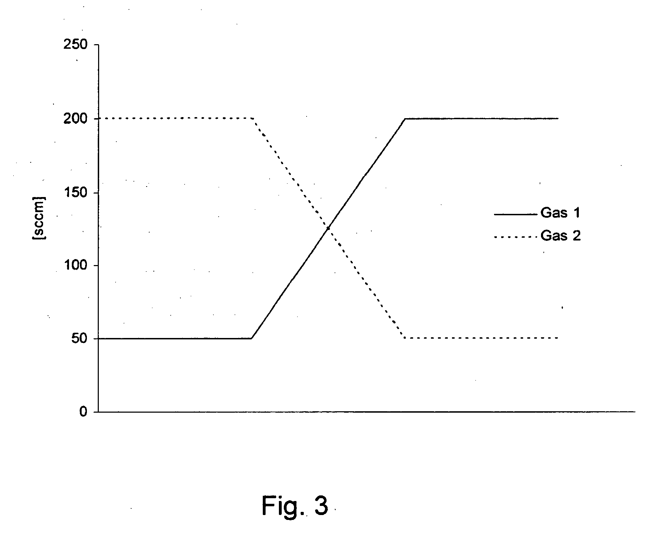

Der Begriff" in Form von gegenläufigen Rampen" soll im Zusammenhang mit der vorliegenden Erfindung bedeuten, dass während des Sputterns, des Plasmareduzierens , des Aufbringens der Haftschicht bzw. des Plasmabeschichtens das Minutenvolumen mindestens eines Reaktionsgases gestuft oder stufenlos reduziert wird, während das Minutenvolumen eines anderen Gases gestuft oder stufenlos erhöht wird (siehe Fig. 3).

Diese Rampen haben in den verschiedenen Schritten jeweils unterschiedliche Funktionen.

Beim Sputtern und beim Plasmareduzieren haben sie den Effekt, dass ein Reaktiorisgas sukzessive durch ein anderes Reaktionsgas verdrängt wird, was für anschließende Prozessschritte, in denen z.B. das zuerst verwendete Reaktionsgas stört, sinnvoll sein kann.

Beim Aufbringen des Haftschicht bzw. beim Plasmabeschichten haben die Rampen den Effekt, dass die Abscheidungsphasen zweier Materialien ineinander übergehen. Auf diese Weise werden Übergangsbereiche mit graduell sich ändernden Anteilen der verschiedenen Beschichtungsmaterialien geschaffen. Dies führt zu einer engeren Verzahnung der beiden Schichten miteinander und somit z.B. zu einer besseren Haftung der Deckschicht an der Haftschicht.

Zentrales Wesen der besagten Rampen ist, das zeitlich koordiniert ein gradueller Übergang von mindestens einem Reaktionsgas zu mindestens einem anderen Reaktionsgas erfolgtem Beschichtungsgas für die Zwischenschicht zum Beschichtungsgas für die Deckschicht muss fließend mit einem bestimmten zeitlichen Gradienten eingestellt werden. Dasselbe gilt ggf. für die Veränderung der Biaszahl sowie ggf. für weitere Beschichtungsparameter.

So muß sichergestellt sein, dass vor jedem Übergang der Reaktionsgase die Kammer auf dem gewollten Biaswert hoch- oder herabgefahren ist, um wiederum die Ausbildung einer Eigenspannung zu vermindern. So muß die sprunghafte Einstellung des Biaswertes mindestens 5 Sekunden vor der Beginn der Einstellung des Gradienten, längstens aber 15 Sekunden vor demselben, erfolgen.

Der Übergang von Schritt b.1) nach Schritt c) kann z.B. so gestaltet sein, dass zunächst eine siliziumhaltige Haftschicht durch Plasmabeschichtung aufgebracht wird. Hierzu wird beispielsweise das bei Raumtemperatur flüssige, jedoch unter hypobaren Bedingungen leicht flüchtige Tetramethyldisiloxan (TMS, C₄H₁₄OSi₂) verwendet. Nach einer gewissen Zeit wird das Gasminutenvolumen für TMS sukzessive reduziert und das Gasminutenvolumen für das Kolhenstoffhaltige Gas Acetylen (Ethen) sukzessive erhöht.

Besagte Rampe könnte wie folgt aussehen: Nach einem optionalen Sputterschritt wird 5 s vor Beginn der Auftragung der Zwischenschicht die Biasspannung V_{Bias} auf für die Beschichtung erforderliche Höhe angehoben. Danach wird mit einer extrem kurze Rampe (10 s) das silanhaltige, verdampfte Gas TMS eingelassen. Nach Ablauf der Abscheidungszeit für die Haftschicht wird das Acetylen-Ventil über einen Zeitraum von 500 s auf den gewünschten Einlasswert graduell geöffnet. Gleichzeitig schließt sich das Ventil für TMS in gleicher Zeit graduell. Anschließend wird die Deckschicht noch über die gewünschte Zeit aufgetragen. Tabelle 8 gibt dieses Verfahren mit beispielhaften Werten wieder:

**Tabelle 8**

| **Schritt** | **V_{bias}** | **TMS (sccm)** | **C₂H₂ (sccm)** | **Druck/ Temp** |
|---|---|---|---|---|
| b.1 | 200 - 500 | 100-500 | 0 | 0,1-2 P |
| (Haftschicht) | | | | 50-150°C |
| Rampe | 350 | 300 | 0 | |
| c | 250 - 600 | 20-150 | 100- 00 | 0,01-0,9 P |
| (Deckschicht) | | | | 50-150°C |

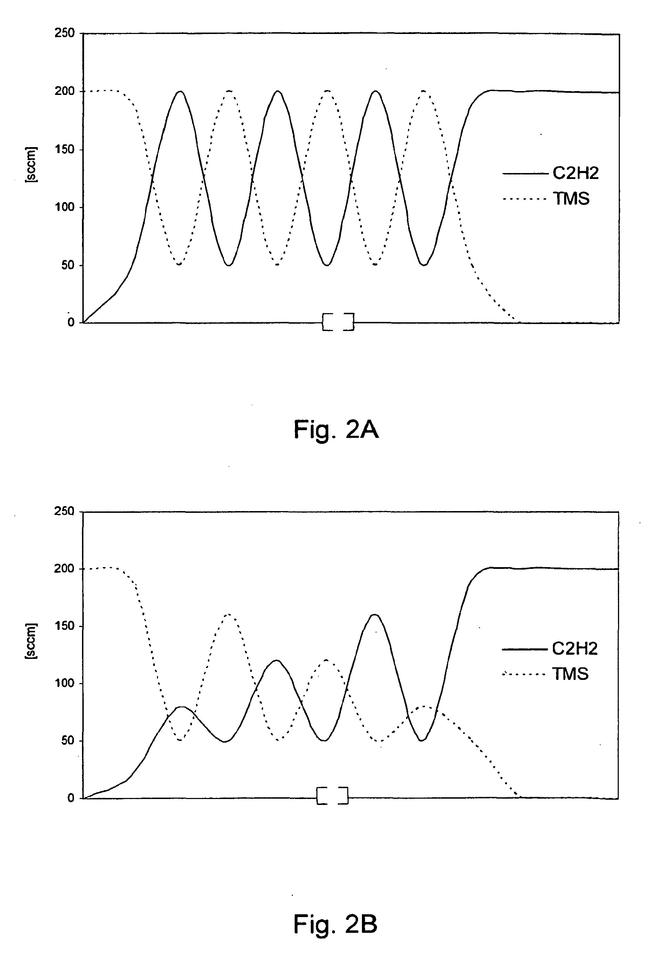

Besonders bevorzugt kann dabei vorgesehen sein, dass für eine Übergangszeit die Gasflussraten für das die Haftschicht generierende Gas (z.B. TMS) und das die Deckschicht generierende Gas (z.B. C₂H₂) periodisch gegeneinander moduliert werden. Dies kann insbesondere mithilfe entsprechend programmierter Mass Flow Controller oder servogesteuerter Nadelventile erreicht werden. Auf diese Weise wird eine besonders innige Haftung erreicht. Siehe hierzu Fig. 2.

Die Aufbringung der Deckschicht (Schritt c) kann im Prinzip beliebig lange dauern. Dabei wächst die Dicke der Deckschicht proportional mit der Beschichtungsdauer. Ebenso kann überdies vorgesehen sein, dass in Bezug auf die für die Haftschicht verwendeten Materialien (Schritt b.1) Rampen gefahren werden. So kann während der Auftragung vorgesehen sein, dass ein Material sukzessive durch ein anderes ersetzt wird.

Beim Aufbringen der Deckschicht in der Plasmabeschichtungskammer (Schritt c) werden überdies bevorzugt folgende Verfahrensparameter eingehalten:

**Tabelle 9**

| **Parameter** | **Wert** |
|---|---|
| Temperatur: | 50 - 150 °C, bevorzugt 80 °C |
| Kammervolumen: | 200 - 10.000 l, bevorzugt 900 l |
| Kammerdruck: | 0.0 - 3.0 Pa, bevorzugt 0.0 - 2.0 Pa |
| Biasspannung: | 200 Volt - 600 Volt |
| Dauer: | 1 - 100 Min. |
| Gasstrom: | 50 sccm - 700 sccm |

Die Gaskonzentration in der Kammer ergibt sich jeweils aus dem Gasfluss, dem Volumen der Kammer sowie dem darin herrschenden Druck. Für eine Kammer mit 900 1 Volumen und einem darin herrschenden Druck von 0,0-2,0 Pa ergibt sich z.B. für Acetylen (C₂H₂) bei einem Gasfluss von 100 sccm (0,1175 g per Minute) eine Konzentration von 0,011% des Kammervolumens. Weitere bevorzugt einzustellende Gasflüsse sind z.B. 200 sccm (0,2350 g per Minute C₂H₂ = 0,022 %), 300 sccm (0,3525 g per Minute C₂H₂ (0,033 %), 400 sccm (0,4700 g per Minute C₂H₂ = 0,044 %) und 500 sccm (0,5875 g per Minute C₂H₂ = 0,055%).

Eine auf diese Weise unter Verwendung von Acetylen als Reaktionsgas hergestellte DLC-Schicht weist eine Härte von 6000 - 8000 HV und eine Dicke von 0,90 µm bis 5,0 µm auf.

Um während dieses Teilschritts die oben genannten nachteiligen Folgen des Sputterns mit Ar₂ zu reduzieren, kann das elektromagnetische Wechselfeld in dieser Zeit heruntergefahren werden. Als Alternative hierzu kann versucht werden, die Dauer dieses Waschschritts möglichst kurz zu halten.

Anschließend wird die Ar₂-Zufuhr schlagartig gestoppt, und es findet der Plasmareduktionsschritt statt, bei welchem H₂ in modulierter Form in die Kammer eingespeist wird, um etwaiges noch vorhandenes Magnesiumoxid zu reduzieren/metallisieren. Anschließend wird TMS in die Kammer eingelassen. In dieser Phase wird nun eine Silizium-Haftschicht auf der durch das Sputtern aktivierten Oberfläche aufgetragen. Zum Zeitpunkt von T = 1600 s wird über eine weitere Rampe das Minutenvolumen von TMS sukzessive reduziert und stattdessen C₂H₂ in die Kammer eingespeist, was zu einem Abscheiden von DLC führt. In der Übergangszeit werden also Silizium und Kohlenstoff zeitgleich abgeschieden, wobei der Siliziumanteil sukzessive reduziert und der Kohlenstoffanteil sukzessive erhöht wird. Auf diese weise wird ein Übergangsbereich zwischen Haft- und hochfester Deckschicht geschaffen, der die Haftung letzterer auf ersterer erheblich verbessert. Anschließend wird die Deckschicht noch über die gewünschte Zeit aufgetragen.

Ferner ist erfindungsgemäß besonders bevorzugt vorgesehen, dass während des Übergangs zwischen Schritt b.1) und Schritt c) die Gaszufuhr der jeweiligen Reaktionsgase zumindest zeitweise gegenläufig moduliert wird.

Auf diese Weise wird ein breiter Übergangsbereich zwischen Haft- und Deckschicht geschaffen und somit die Haftung verbessert und das Auftreten von Spannungen reduziert. Dabei kann vorgesehen sein, dass die Amplitude der periodischen Gaszufuhr des Reaktionsgases für die Haftschicht abnimmt, während die Amplitude der periodischen Gaszufuhr des Reaktionsgases für sie Deckschicht im Laufe der Zeit zunimmt. Siehe in Bezug auf diese Ausführungsformen insbesondere Fig. 3.

Überdies hat sich als vorteilhaft herausgestellt, wenn während des gesamten Beschichtungsprozess der Deckschicht in Schritt c) "Dauergradienten" gefahren werden, um spannungsarme Deckschichten zu erhalten. Dies bedeutet in der Praxis, dass während des gesamten Beschichtungsprozesses der Deckschicht das Minutenvolumen der Gaszufuhr niemals konstant bleibt, sondern periodisch moduliert wird die Biasspannung jedoch konstant gehalten wird. Auf diese Weise kann z.B. eine DLC- Deckschicht mit einer Dicke von bis zu 10µ spannungsarm aufgebracht werden. Siehe in Bezug auf diese Ausführungsformen insbesondere Fig 1.

Erfindungsgemäß ist ferner Vorgesehen, dass das Verfahren in einer Plasmabeschichtungskammer durchgeführt wird, aufweisend eine flächige Hochfrequenzelektrode zur Erzeugung eines elektromagnetischen Wechselfeldes, und einen außerhalb der Kammer angeordneten Frequenzgenerator, dadurch gekennzeichnet, dass die Hochfrequenzelektrode mindestens zwei Zuleitungen aufweist, über welche sie mit einer vom Frequenzgenerator erzeugten Wechselspannung versorgt wird.

Durch die mindestens zwei Zuleitungen wird eine bessere Homogenität des elektromagnetischen Wechselfeldes herbeigefiihrt, wie in der WO2008006856 beschrieben ist, die auf den selben Erfinder wie die vorliegende Erfindung zurückgeht, und deren Offenbarungsgehalt dem der vorliegenden Anmeldung als zugefügt gelten soll.

Erfindungsgemäß ist ferner die Verwendung einer Plasmabeschichtungskammer vorgesehen, letztere aufweisend eine flächige Hochfrequenzelektrode zur Erzeugung eines elektromagnetischen Wechselfeldes, einen außerhalb der Kammer angeordneten Frequenzgenerator, sowie mindestens zwei Zuleitungen aufweist, über welche die Hochfrequenzelektrode mit einer vom Frequenzgenerator erzeugten Wechselspannung versorgt wird. Erfindungsgemäß dient dies Verfahren zum Aufbringen einer Beschichtung auf Werkstücke und/oder Werkstoffe gemäß obiger Beschreibung.

Ebenso ist erfindungsgemäß ein Werkstück und/oder Werkstoff aufweisend mindestens ein leicht oxidierbares Nichteiserunetall vorgesehen, wobei dieses eine mittels Plasmabeschichtungsverfahren aufgetragene Beschichtung aufweist.

Besagtes Werkstück bzw. besagter Werkstoff weist in einer bevorzugten Ausführungsform in seiner Beschichtung mindestens einen Bestandteil ausgewählt aus der Gruppe enthaltend:
- Kohlenstoff, insbesondere DLC (Diamond Like Carbon)
- Silizium
- Titan,
- Wolfram,
- Wolframcarbid,
- Vanadium, und/oder
- Kupfer
auf.

Ferner ist besagtes Werkstück und/oder besagter Werkstoff bevorzugt mit einem Verfahren gemäß obiger Beschreibung herstellbar.

### Beispiele und Zeichnungen

Fig. 1 zeigt beispielhaft die oben beschriebene periodische Modulation des Reaktionsgases in Schritt b) des erfindungsgemäßen Verfahrens, also bei der Plasmareduktion. Wir bereits erwähnt kommt als Reaktionsgas bevorzugt Wasserstoffgas zum Einsatz. Durch die periodische Modulation kann erreicht werden, dass zu bestimmten Phasen viel Reaktionsgas in die Kammer strömt, während zu anderen Phasen nur wenig Reaktionsgas in die Kammer strömt. Durch die periodische Modulation des Reaktionsgas-Zuflusses wird der zerklüfteten Oberfläche des Werkstücks und/oder Werkstoffs Rechnung getragen, denn nur so gelingt es, sowohl in tiefen Riefen und Mikrokavitäten der Oberfläche des Werkstücks und/oder Werkstoffs vorhandene Metalloxidreste als auch an flachen Passagen der Oberfläche anhaftende Metalloxidreste ausreichend gründlich zu reduzieren.

Die Modulation kann z.B sinusförmig (Fig. 1A) aber auch Sägezahnförmig (Fig. 1A) erfolgen. Weitere, nicht dargestellte Optionen sind eine dreieck- oder eine rechteckförmige Modulation. Bei letzterer wird zischen zwei unterschiedlichen fixen Gasflussraten hin- und hergeschaltet.

Fig. 2 zeigt bevorzugte Möglichkeiten der Ausgestaltung des Übergangs zwischen Schritt b.1) (Aufbringen einer Haftschicht mittels Plasmabeschichtung) und Schritt c) (Aufbringen einer Deckschicht durch Plasmabeschichtung). Dabei ist vorgesehen, dass für eine Übergangszeit die Gasflussraten für das die Haftschicht generierende Gas (z.B. TMS) und das die Deckschicht generierende Gas (z.B. C₂H₂) periodisch gegeneinander moduliert werden. Dies kann insbesondere mithilfe entsprechend programmierter Mass Flow Controller oder servogesteuerter Nadelventile erreicht werden. Auf diese Weise wird eine besonders innige Haftung erreicht. Die Modulation kann, wie in Fig. 2A dargestellt, sinusförmig erfolgen. Natürlich ist auch seine sägezahn-, dreieck- oder rechteckförmige Modulation denkbar.

Besonders bevorzugt unterliegt die Modulation dabei einer gegenläufigen Modifikation, wie sie in Fig. 2B dargestellt ist. So kann z.B. die Amplitude und der Median der Gasflussrate für das die Haftschicht generierende Gas sukzessive heruntergefahren werden, während die Amplitude und der Median der Gasflussrate für dass die Deckschicht generierende Gas sukzessive heraufgefahren werden kann. Dies kann wie dargestellt bei sinusförmiger Modulation erfolgen, ebenso jedoch auch bei sägezahn-, dreieck- oder rechteckförmiger Modulation.

Fig. 3 zeigt das generelle Konzept der Verwendung gegenläufiger Rampen. Diese Rampen haben in den verschiedenen Schritten jeweils unterschiedliche Funktionen.
Beim Sputtern und beim Plasmareduzieren haben sie den Effekt, dass ein Reaktionsgas sukzessive durch ein anderes Reaktionsgas verdrängt wird, was für anschließende Prozessschritte, in denen z.B. das zuerst verwendete Reaktionsgas stört, sinnvoll sein kann.

Beim Aufbringen des Haftschicht bzw. beim Plasmabeschichten haben die Rampen den Effekt, dass die Abscheidungsphasen zweier Materialien ineinander übergehen. Auf diese Weise werden Übergangsbereiche mit graduell sich ändernden Anteilen der verschiedenen Beschichtungsmaterialien geschaffen. Dies führt zu einer engeren Verzahnung der beiden Schichten miteinander und somit z.B. zu einer besseren Haftung der Deckschicht an der Haftschicht.

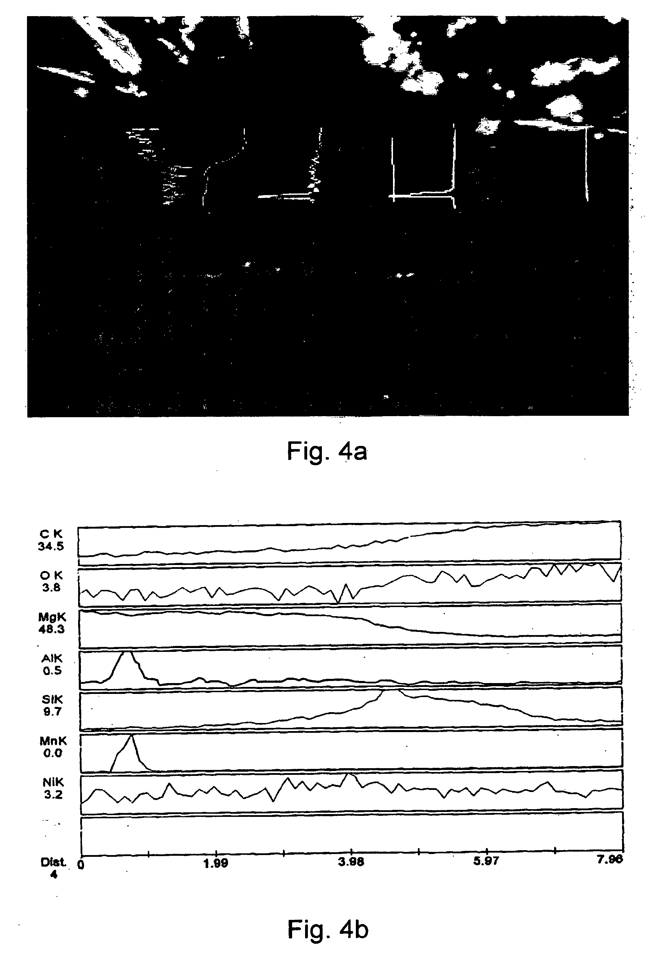

Fig. 4a zeigt eine rasterelektronenmikroskopische Abbildung (2000-fache Vergrößerung) eines Schnitts eines erfindungsgemäß mit DLC beschichteten Werkstücks aus einem Magnesiumwerkstoff. Im unteren Bereich von Fig. 4a ist das Werkstück zu erkennen, während im oberen Bereich das Einbettungsmedium (erkennbar an den hellen Luftblasen) abgebildet ist.

Überlagert sind dieser Abbildung die mittels Röntgendiffraktometrie (XRD) ermittelten Konzentrationsverläufe von Kohlenstoff (C), Sauerstoff (O), Magnesium (Mg), Aluminium (Al), Silizium (Si), Mangan (Mn) und Nickel (Ni) im Übergangsbereich zwischen Werkstück, Beschichtung und Einbettungsmedium. Die Messung und Überlagerung erfolgte mit der Software "Genesis" der Firma Edax.

In Fig. 4b sind diese Konzentrationsverläufe noch einmal gesondert dargestellt, dabei ist die Konzentration jeweils über eine Strecke von 8 µm geplottet (Angaben in Gewichtsprozent am Gesamtgewicht der untersuchten Probe). Aufgrund der Autoskalierung weisen solche Elemente, für die keine signifikanten Konzentrationsänderungen nachweisbar sind, eine starke Verrauschung auf (so z.B. die Verläufe für Sauerstoff und Nickel), hierbei handelt es sich um Bitrauschen. Wie zu erwarten ist eine hohe Konzentration für Magnesium im Bereich des Werksticks sowie eine hohe Kohlenstoffkonzentration im Bereich der DLC-Beschichtung gut erkennbar. Im Übergangsbereich verhält sich die Konzentration beider Elemente gegenläufig, was durch die erwähnte Rampe zu Beginn von Schritt c) verursacht wird. Gut erkennbar ist ebenso, dass ziemlich genau im Übergangsbereich die Konzentration von Si kurzzeitig sprunghaft ansteigt. Hier bei handelt es sich um die (erfindungsgemäß optionale) siliziumhaltige Haftschicht, die in Schritt b.1) mittels Plasmabeschichtung unter Verwendung von TMS als Reaktionsgas aufgebracht wird. Die noch im Bereich des Werkstücks vorgefundenen kurzzeitigen sprunghaften Anstiege von Aluminium und Mangan sind auf eine Verunreinigung im Werkstück zurückzuführen. Wichtig ist ferner, dass im Übergangsbereich zwischen Werkstück und Beschichtung keine signifikant höhere Konzentration von Sauerstoff festzustellen ist. Dies weist darauf hin, dass die erfindungsgemäß vorgenommene Metallisierung gemäß Schritt b) durch Plasmareduktion sehr effizient sämtlichen Sauerstoff aus dem Material ausgetrieben hat, so dass dieses dann erfolgreich und dauerhaft mit DLC beschichtet werden kann.

## Patentansprüche

1. Verfahren zum Aufbringen einer Beschichtung auf Werkstücke und/oder Werkstoffe aufweisend mindestens ein Metall oder eine Metalllegierung, das bzw. die im Vergleich zu Eisen ein negatives Standardpotential aufweist, das Verfahren aufweisend die folgenden Schritte:
b) Vorbehandlung des Werkstücks und/oder Werkstoffs mittels Plasmareduktion
c) Aufbringen einer Deckschicht durch Plasmabeschichtung in einer Plasmabeschichtungskammer,
wobei in Schritt b) der Zufluss des Reaktionsgases periodisch moduliert wird.

2. Verfahren nach Anspruch 1, **dadurch gekennzeichnet, dass** es sich bei dem Metall oder der Metalllegierung, das bzw. die im Vergleich zu Eisen ein negatives Standardpotential aufweist um mindestens ein Metall ausgewählt aus der Gruppe enthaltend Zinn, Zink, Titan, Aluminium, Beryllium, und/oder Magnesium handelt.

3. Verfahren gemäß einem der vorhergehenden Ansprüche, **dadurch gekennzeichnet, dass** das Reaktionsgas in Schritt b) mindestens Wasserstoff aufweist.

4. Verfahren gemäß Anspruch 1, aufweisend vor oder zeitgleich mit Schritt b) mindestens einen Schritt
a.2) Aktivieren des Werkstücks und/oder des Werkstoffs durch Sputtern.

5. Verfahren gemäß einem der vorhergehenden Ansprüche, aufweisend vor Schritt b) mindestens einen Schritt
a.1) Behandlung der Oberfläche des Werkstücks und/oder Werkstoffs durch mindestens ein abrasives Verfahren

6. Verfahren nach einem der vorgehenden Ansprüche, **dadurch gekennzeichnet, dass** es sich bei dem leicht oxidierbaren Nichteisenmetall oder seiner Legierung um Magnesium bzw. eine Magnesiumlegierung handelt.

7. Verfahren gemäß einem der vorhergehenden Ansprüche, **dadurch gekennzeichnet, dass** es sich bei der Deckschicht um eine Schicht ausgewählt aus der Gruppe enthaltend
• Kohlenstoffhaltige Schichten
• Siliziumhaltige Schichten
• Titanhaltige Schichten
• Wolframhaltige Schichten
• Wolframcarbidhaltige Schichten
• Vanadiumhaltige Schichten, und/oder
• Kupferhaltige Schichten.

8. Verfahren gemäß einem der vorhergehenden Ansprüche, **dadurch gekennzeichnet, dass** ein fester oder flüssiger Precursor für ein Reaktionsgas in einem der Plasmabeschichtungskammer vorgeschalteten Gasversorgungssystem erhitzt und unter Vakuum in die Dampfphase gebracht und anschließend über eine Gaszufuhreinrichtung in die Plasmabeschichtungskammer eingespeist wird.

9. Verfahren gemäß einem der vorhergehenden Ansprüche, **dadurch gekennzeichnet, dass** zwischen Schritt b) und Schritt c) der Schritt
b.1) Aufbringen einer Haftschicht mittels Plasmabeschichtung
erfolgt.

10. Verfahren gemäß Anspruch 9, **dadurch gekennzeichnet, dass** die Haftschicht Elemente aus der 6. und 7. Nebengruppe aufweist.

11. Verfahren gemäß einem der vorhergehenden Ansprüche, **dadurch gekennzeichnet, dass** die Gaszufuhr mindestens zwei verschiedener Gase
• in Schritt a.2),
• beim Übergang von Schritt a.2) nach Schritt b)
• beim Übergang von Schritt b) nach Schritt b.1) oder Schritt c)
• beim Übergang von Schritt b.1) nach Schritt c)
in Form von gegenläufigen Rampen erfolgt.

12. Verfahren gemäß Anspruch 9, **dadurch gekennzeichnet, dass** während des Übergangs zwischen Schritt b.l) und Schritt c) die Gaszufuhr der jeweiligen Reaktionsgase zumindest zeitweise gegenläufig moduliert wird.

13. Verfahren gemäß einem der vorhergehenden Ansprüche, wobei das Verfahren in einer Plasmabeschichtungskammer durchgeführt wird, aufweisend eine flächige Hochfrequenzelektrode zur Erzeugung eines elektromagnetischen Wechselfeldes, und einen außerhalb der Kammer angeordneten Frequenzgenerator, **dadurch gekennzeichnet, dass** die Hochfrequenzelektrode mindestens zwei Zuleitungen aufweist, über welche sie mit einer vom Frequenzgenerator erzeugten Wechselspannung versorgt wird.

14. Verwendung einer Plasmabeschichtungskammer aufweisend eine flächige Hochfrequenzelektrode zur Erzeugung eines elektromagnetischen Wechselfeldes, einen außerhalb der Kammer angeordneten Frequenzgenerator, sowie mindestens zwei Zuleitungen, über welche die Hochfrequenzelektrode mit einer vom Frequenzgenerator erzeugten Wechselspannung versorgt wird, zum Aufbringen einer Beschichtung auf Werkstücke und/oder Werkstoffe gemäß einem der vorherigen Verfahrensansprüche.

## Claims

1. A process for coating of work pieces and/or materials comprising at least a metal or a metal alloy, comprising a negative standard electrode potential in comparison to iron, wherein the process comprises the following steps:
b) pre-treatment of the work piece and/or the material using plasma reduction,
c) deposition of a cover layer in a plasma coating chamber using plasma coating,
wherein in step b) the influx of the reaction gas is modulated periodically.

2. The process according to claim 1, **characterised in that** the metal or the metal alloy, wherein the metal or the metal alloy comprises in comparison to iron a negative standard electrode potential, is at least a metal selected from the group comprising tin, zinc, titanium, aluminum, beryllium, and/or magnesium.

3. The process according to any of the preceding claims, **characterised in that** the reaction gas in step b) comprises at least hydrogen.

4. The process according to claim 1, comprising before or at the same time with step b) at least a step
a.2) activation of the work piece and/or the material by sputtering.

5. The process according to any of the preceding claims, comprising before step b) at least a step
a.1) surface treatment of the work piece and/or the material by at least one abrasive process.

6. The process according to any of the preceding claims, **characterised in that** the easy oxidisable non-iron metal or alloy thereof is magnesium respectively a magnesium alloy.

7. The process according to any of the preceding claims, **characterised in that** the cover layer is a layer selected from the group comprising
• carbon containing layers
• silicium containing layers
• titanium containing layers
• wolfram containing layers
• wolfram carbide containing layers
• vanadium containing layers, and/or
• copper containing layers.

8. The process according to any of the preceding claims, **characterised in that** a solid or liquid precursor for a reaction gas is heated in a gas supply system which is arranged upstream of a plasma coating chamber and is brought into the vapour phase by application of a vacuum and is after that fed into the plasma coating chamber by a gas supply device.

9. The process according to any of the preceding claims, **characterised in that** in between step b) and step c) the step
b.1) application of an undercoating using plasma coating
is performed.

10. The process according to claim 9, **characterised in that** the undercoating comprises elements from the 6th and the 7th subgroup.

11. The process according to any of the preceding claims, **characterised in that** the gas supply of at least two different gases
• in step a.2),
• in transition from step a.2) to step b),
• in transition from step b) to step b.1) or step c),
• in transition from step b.1) to step c)
is carried out in the form of opposing ramps.

12. The process according to claim 9, **characterised in that** within the transition from step b.1) and step c) the gas supply of the particular reaction gases is at least temporarily modulated in opposite directions.

13. The process according to any of the preceding claims, **characterised in that** the process is performed in a plasma coating chamber, wherein the plasma coating chamber comprises a 2-dimensional high-frequency electrode for generating an electro-magnetic oscillating field, and a frequency generator arranged outside of the chamber, **characterised in that** the high-frequency electrode comprises at least 2 supply lines, feeding alternating current voltage generated by the frequency generator to the high-frequency electrode.

14. Use of a plasma coating chamber comprising a 2-dimensional high-frequency electrode for generation of an electromagnetic alternating field, a high-frequency generator arranged outside of the chamber, as well as at least to supply lines feeding the high-frequency electrode with the alternating current voltage generated by the frequency generator, for coating of a work piece and/or material according to any of the preceding process claims.

## Revendications

1. Procédé pour déposer un revêtement sur des pièces et/ou matériaux comportant au moins un métal ou un alliage de métaux lequel présente, par rapport à du fer, un potentiel standard négatif, ledit procédé comportant les étapes suivantes consistant à :
b) prétraiter la pièce et/ou le matériau au moyen de réduction assistée par plasma
c) déposer une couche de couverture par revêtement assisté par plasma dans une chambre de revêtement assisté par plasma,
dans l'étape b) l'alimentation en gaz réactif étant modulée périodiquement.

2. Procédé selon la revendication 1, **caractérisé en ce qu'**il s'agit en ce qui concerne le métal ou l'alliage de métaux, lequel présente par rapport à du fer un potentiel standard négatif, d'au moins un métal choisi dans le groupe contenant de l'étain, du zinc, du titane, de l'aluminium, du béryllium et/ou du magnésium.

3. Procédé selon l'une des revendications précédentes, **caractérisé en ce que** le gaz réactif dans l'étape b) comporte au moins de l'hydrogène.

4. Procédé selon la revendication 1 comportant, avant ou en même temps que l'étape b), au moins une étape consistant à :
a.2) activer la pièce et/ou le matériau par pulvérisation cathodique.

5. Procédé selon l'une des revendications précédentes comportant, avant l'étape b), au moins une étape consistant à
a.l) traiter la surface de la pièce et/ou du matériau par le biais d'au moins un procédé abrasif.

6. Procédé selon l'une des revendications précédentes, **caractérisé en ce qu'**il s'agit en ce qui concerne le métal non-ferreux facilement oxydable, ou son alliage, de magnésium ou d'un alliage de magnésium.

7. Procédé selon l'une des revendications précédentes, **caractérisé en ce qu'**il s'agit en ce qui concerne la couche de couverture d'une couche choisie dans le groupe contenant
• des couches contenant du carbone
• des couches contenant du silicium
• des couches contenant du titane
• des couches contenant du tungstène
• des couches contenant du carbure de tungstène
• des couches contenant du vanadium, et/ou
• des couches contenant du cuivre.

8. Procédé selon l'une des revendications précédentes, **caractérisé en ce qu'**un précurseur solide ou liquide d'un gaz réactif dans un système d'alimentation en gaz disposé en amont de la chambre de revêtement assisté par plasma est chauffé et amené sous vide en phase vapeur et ensuite introduit par un organe d'introduction de gaz dans la chambre de revêtement assisté par plasma.

9. Procédé selon l'une des revendications précédentes, **caractérisé en ce qu'**entre l'étape b) et l'étape c) l'étape consistant à
b.l) déposer une couche d'adhérence au moyen de revêtement assisté par plasma
a lieu.

10. Procédé selon la revendication 9, **caractérisé en ce que** la couche d'adhérence comporte des éléments du 6ème et 7ème groupe du tableau périodique.

11. Procédé selon l'une des revendications précédentes, **caractérisé en ce que** l'introduction de gaz d'au moins deux gaz différents, a lieu
• dans l'étape a.2),
• lors du passage de l'étape a.2) à l'étape b)
• lors du passage de l'étape b) à l'étape b.1) ou l'étape c)
• lors du passage de l'étape b.1) à l'étape c)
sous forme de rampes à inclinaisons opposées.

12. Procédé selon la revendication 9, **caractérisé en ce que**, pendant le passage entre l'étape b.1) et l'étape c), l'introduction des différents gaz réactifs est modulée dans des sens opposés, au moins temporairement.

13. Procédé selon l'une des revendications précédentes, ledit procédé étant réalisé dans une chambre de revêtement assisté par plasma laquelle comporte une électrode plate à haute fréquence pour la génération d'un champ électromagnétique alternatif, et un générateur de fréquence disposé à l'extérieur de la chambre, **caractérisé en ce que** l'électrode à haute fréquence comporte au moins deux lignes d'alimentation, par lesquelles elle est alimentée en une tension alternative générée par le générateur de fréquence.

14. Utilisation d'une chambre de revêtement assisté par plasma, laquelle comporte une électrode plate à haute fréquence pour la génération d'un champ électromagnétique alternatif, un générateur de fréquence disposé à l'extérieur de la chambre, ainsi qu'au moins deux lignes d'alimentation, par lesquelles l'électrode à haute fréquence est alimentée en une tension alternative générée par le générateur de fréquence, pour déposer un revêtement sur des pièces et/ou matériaux selon l'une des revendications de procédé précédentes.
